# EUROPEAN PATENT APPLICATION

(11) **EP 4 739 036 A1**
(43) Date of publication of application: **06.05.2026**
(21) Application number: 25204141.3
(22) Date of filing: 23.09.2025
(51) Int. Cl.: H10D 89/60, H02H 9/04

(54) **CHIP WITH ELECTROSTATIC DISCHARGE PROTECTION**

(30) Priority: 29.10.2024 US 202463713092 P; 06.08.2025 US 202519291741
(71) Applicant: MEDIATEK INC., Hsinchu City 30078 (TW)
(72) Inventor: WU, Han-Hsin, 30078 Hsinchu City (TW); CHEN, Yi-Lun, 30078 Hsinchu City (TW)
(74) Representative: Haseltine Lake Kempner LLP

(57) **Abstract**

A chip with electrostatic discharge protection is shown. The chip has an output driver and an electrostatic discharge (ESD) protection control circuit. The output driver has a first output driver transistor coupled between an input/output (I/O) pad of the chip and ground, and a second output driver transistor coupled between a power source and the I/O pad. The ESD protection control circuit has a first output terminal coupled to a control terminal of the first output driver transistor, to control the first output driver transistor for electrostatic discharge protection. The ESD control circuit is enabled in response to electrostatic disturbance at the I/O pad.

## Description

### TECHNICAL FIELD

The present disclosure relates to electrostatic discharge (ESD) protection.

### BACKGROUND

A conventional chip design may use large array devices for electrostatic discharge (ESD) self-protection. If the output driver is incapable of ESD self-protection, additional ESD cells are required.

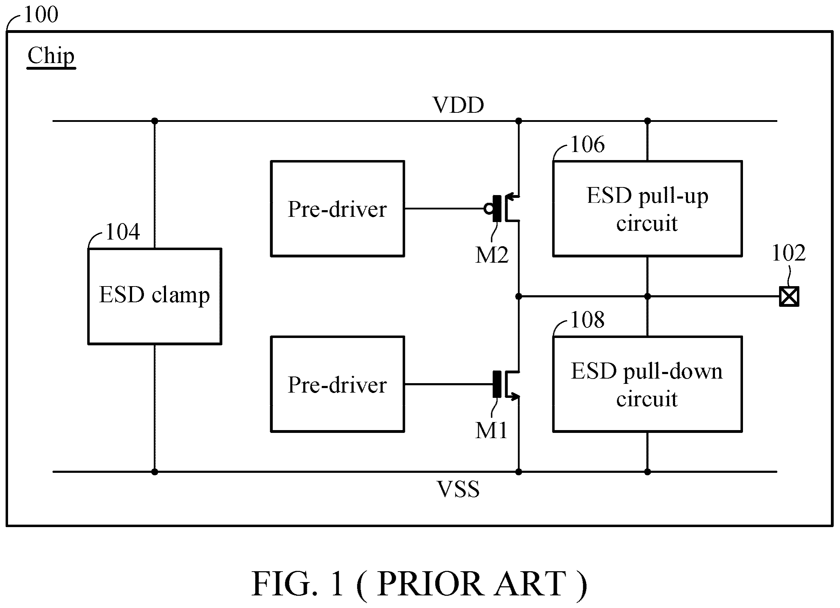

FIG. 1 depicts a conventional ESD protection design for an input/output (I/O) pad 102 of a chip 100. The chip 100 comprises an output driver (a buck converter, for example) formed by a first output driver transistor M1 (coupled between the I/O pad 102 and the ground VSS) and a second output driver M2 (coupled between the power source VDD and the I/O pad 102). In addition to an ESD clamp 104 between the power source VDD and the ground VSS, an ESD pull-up circuit 106 is required between the power source VDD and the I/O pad 102, and an ESD pull-down circuit 108 is required between the I/O pad 102 and the ground VSS.

However, the ESD pull-up circuit 106 and the ESD pull-down circuit 108 may result in performance degradation of the chip 100, and may form leakage paths in the normal operations of the chip 100.

### BRIEF SUMMARY

A chip with electrostatic discharge (ESD) protection is shown. Instead of using additional ESD pull-up circuit or ESD pull-down circuit, an electrostatic discharge (ESD) protection control circuit controlling the output driver transistors is shown.

A chip with ESD protection in accordance with an exemplary embodiment of the disclosure includes an output driver and an ESD protection control circuit. The output driver has a first output driver transistor coupled between the input/output (I/O) pad of the chip and ground, and a second output driver transistor coupled between a power source and the I/O pad. The ESD protection control circuit has a first output terminal coupled to a control terminal of the first output driver transistor, to control the first output driver transistor for ESD protection. The ESD protection control circuit is enabled in response to electrostatic disturbance at the I/O pad.

In an exemplary embodiment, the chip has an electrostatic discharge clamp. The ESD protection control circuit turns off the first output driver transistor in response to positive electrostatic disturbance at the I/O pad, and thereby an electrostatic discharge current from the I/O pad is directed to the ground through a parasitic diode of the second output driver transistor and the electrostatic discharge clamp.

In an exemplary embodiment, the ESD protection control circuit turns on the first output driver transistor in response to positive electrostatic disturbance at the I/O pad, and thereby an electrostatic discharge current from the I/O pad is directed to the ground through the first output driver transistor.

In an exemplary embodiment, the ESD protection control circuit further has a second output terminal coupled to a control terminal of the second output driver transistor, to control the second output driver transistor for ESD protection.

In an exemplary embodiment, the chip has an electrostatic discharge clamp. The ESD protection control circuit turns off the second output driver transistor in response to negative electrostatic disturbance at the I/O pad, and thereby an electrostatic discharge current from the power source is directed to the I/O pad through the electrostatic discharge clamp and a parasitic diode of the first output driver transistor.

In an exemplary embodiment, the ESD protection control circuit turns on the second output driver transistor in response to negative electrostatic disturbance at the I/O pad, and thereby an electrostatic discharge current from the power source is directed to the I/O pad through the second output driver transistor.

In an exemplary embodiment, the ESD protection control circuit only controls the second output driver transistor in response to negative electrostatic disturbance at the I/O pad.

A detailed description is given in the following embodiments with reference to the accompanying drawings.

### BRIEF DESCRIPTION OF THE DRAWINGS

The present disclosure can be more fully understood by reading the subsequent detailed description and examples with references made to the accompanying drawings, wherein:
FIG. 1 depicts a conventional ESD protection design for an input/output (I/O) pad 102 of a chip 100;
FIG. 2 shows a chip 200 in accordance with an exemplary embodiment of the disclosure;
FIG. 3A and FIG. 3B show the ESD locking for the first output driver transistor M1 in accordance with an exemplary embodiment of the disclosure;
FIG. 4A and FIG. 4B show the ESD locking for the second output driver transistor M2 in accordance with an exemplary embodiment of the disclosure;
FIG. 5A and FIG. 5B show the ESD locking for an NMOS M2 in accordance with an exemplary embodiment of the disclosure;
FIG. 6A and FIG. 6B show the ESD protection based on MOS triggering of the first output driver transistor M1 in accordance with an exemplary embodiment of the disclosure;
FIG. 7A and FIG. 7B show the ESD protection based on MOS triggering of the second output driver transistor M2 in accordance with an exemplary embodiment of the disclosure; and
FIG. 8A and FIG. 8B show the ESD protection based on MOS triggering of the NMOS M2 in accordance with an exemplary embodiment of the disclosure.

### DETAILED DESCRIPTION

The following description enumerates various embodiments of the disclosure, but is not intended to be limited thereto. The actual scope of the disclosure should be defined according to the claims. The various blocks may be implemented by special circuits. The circuit components may be directly connected to each other without additional components as the circuit illustrated in the figures. Or, there may be some additional components coupled between the illustrated circuit components.

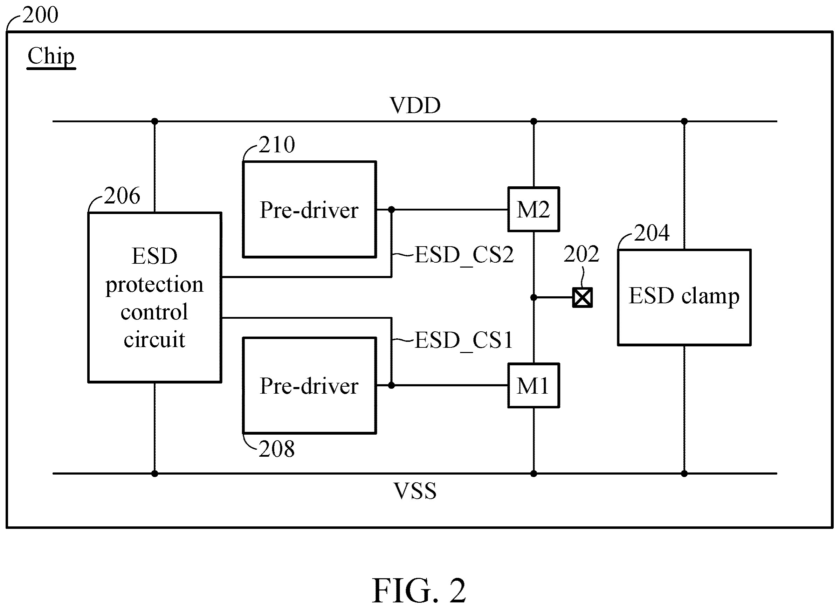

FIG. 2 shows a chip 200 in accordance with an exemplary embodiment of the disclosure. In the chip 200, a first output driver transistor M1 and a second output driver transistor M2 form an output driver. The first output driver transistor M1 is coupled between an input/output (I/O) pad 202 of the chip 200 and ground VSS. The second output driver transistor M2 is coupled between a power source VDD and the I/O pad 202. The chip 200 has an electrostatic discharge (ESD) clamp 204 that is coupled between the power source VDD and the ground VSS. In this disclosure, no additional ESD pull-up circuit (between the power source VDD and the I/O pad 202) or ESD pull-down circuit (between the I/O pad 202 and the ground VSS) is required. Instead, the chip 200 has an electrostatic discharge (ESD) protection control circuit 206, which has a first output terminal ESD_CS1 coupled to a control terminal of the first output driver transistor M1 to control the first output driver transistor M1 for electrostatic discharge protection, or/and has a second output terminal ESD_CS2 that is coupled to a control terminal of the second output driver transistor M2 to control the second output driver transistor M2 for electrostatic discharge protection. Note that the ESD protection circuit 206 is different from the pre-drivers 208 and 210. The pre-drivers 208 and 210 are coupled to the control terminals of the first and second output driver transistors M1 and M2 for normal operation of the output driver. The ESD protection control circuit 206 is enabled in response to electrostatic disturbance at the I/O pad 202. In normal operations, the ESD protection control circuit 206 is disabled, not affecting the normal operations of the pre-drivers 208 and 210.

The ESD protection may be achieved by locking the weak transistors.

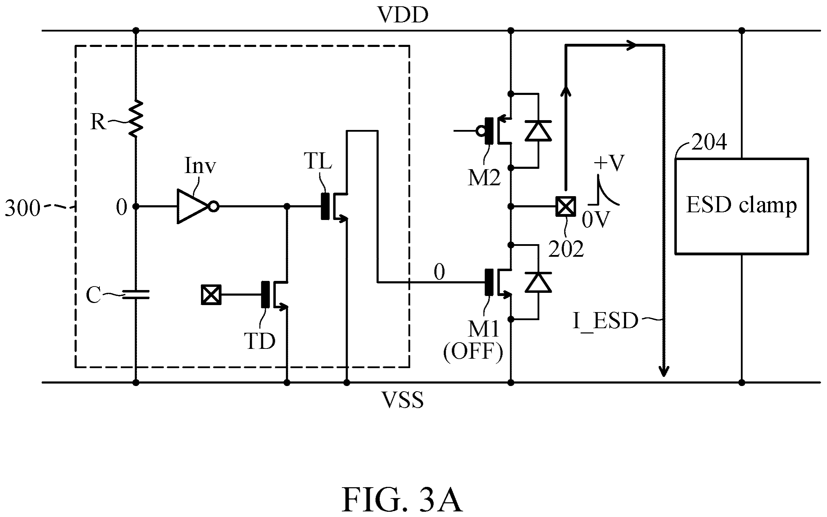

FIG. 3A illustrates an ESD protection control circuit 300 in accordance with an exemplary embodiment of the disclosure. The ESD protection control circuit 300 locks (turns off) the first output driver transistor M1 in response to positive electrostatic disturbance (e.g., 0V to +V) at the I/O pad 202. In this manner, an electrostatic discharge current I_ESD from the I/O pad 202 is directed to the ground VSS through a parasitic diode of the second output driver transistor M2 and the electrostatic discharge clamp 204. The weak transistor M1 is protected from damage.

In this example, the first output driver transistor M1 is an n-type metal-oxide-semiconductor field-effect transistor (NMOS), having a drain terminal coupled to the I/O pad 202, and a source terminal coupled to the ground VSS. The ESD protection control circuit 300 has a resistor R and a capacitor C, which are coupled between the power source VDD and the ground VSS. The ESD protection control circuit 300 further has an inverter Inv and a lock transistor TL. The inverter Inv has an input terminal coupled to a connection terminal between the resistor R and the capacitor C. The lock transistor TL is an NMOS, having a gate terminal coupled to an output terminal of the inverter Inv, a drain terminal coupled to a gate terminal of the first output driver transistor M1, and a source terminal coupled to the ground Vss. In response to the positive electrostatic disturbance at the I/O pad 202, the connection terminal between the resistor R and the capacitor C is low (0), so that the inverter Inv outputs high (1) to turn on the lock transistor TL to lock (turn off) the first output driver transistor M1. The ESD current I_ESD is bypassed through the safe path, and the first output driver transistor M1 is well protected from damage by the ESD event.

The ESD protection control circuit 300 further has a disable transistor TD (optional). The disable transistor TD is an NMOS having a source terminal coupled to the ground VSS, a drain terminal coupled to the gate terminal of the lock transistor TL, and a gate terminal. In FIG. 3A, the disable transistor TD does not work. The ESD protection control circuit 300 operates to deal with the electrostatic disturbance.

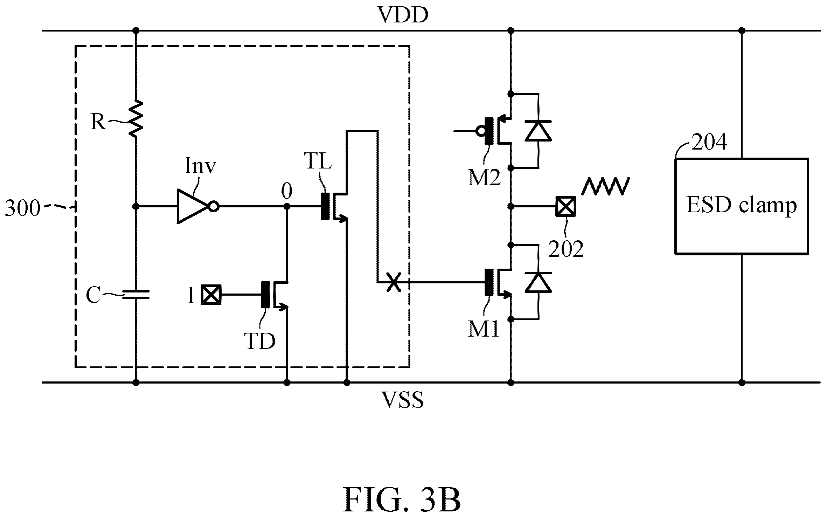

FIG. 3B shows the normal operations of the output driver. An asserted signal '1' is coupled to the gate terminal of the disable transistor TD. Accordingly, the ESD control circuit 300 is disabled without affecting the normal operations of the output driver.

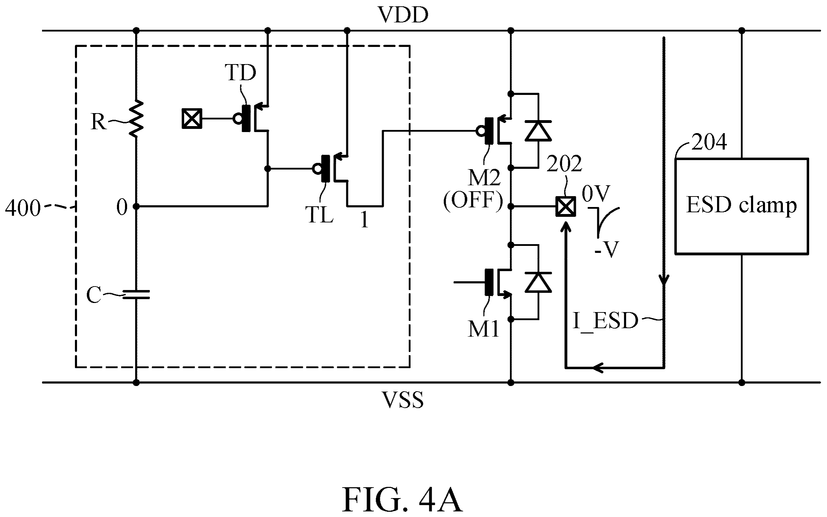

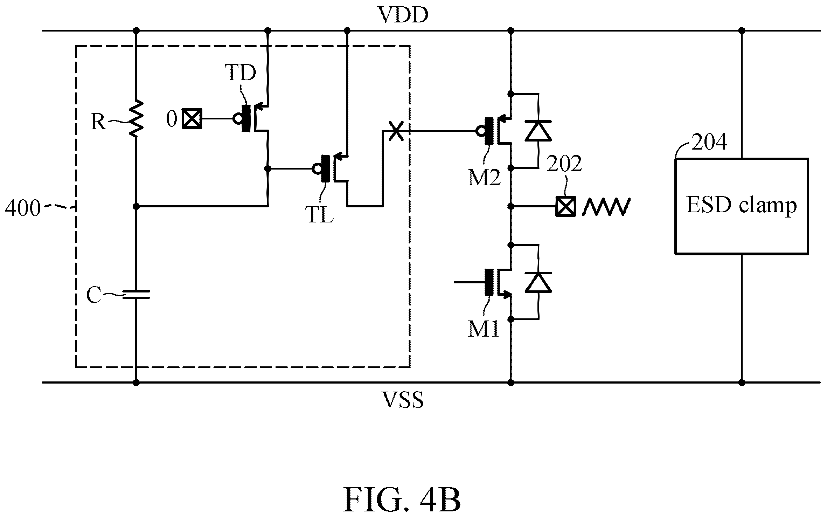

FIG. 4A and FIG. 4B show the ESD locking for the second output driver transistor M2 in accordance with an exemplary embodiment of the disclosure. Referring to FIG. 4A, in response to negative electrostatic disturbance (e.g., from 0V to -V) at the I/O pad 202, the ESD protection control circuit 400 turns off the second output driver transistor M2, and thereby an electrostatic discharge current I_ESD from the power source VDD is directed to the I/O pad 202 through the ESD clamp 204 and a parasitic diode of the first output driver transistor M1. The weak transistor M2 is protected from damage.

In this example, the second output driver transistor M2 is a p-type metal-oxide-semiconductor field-effect transistor (PMOS), having a source terminal coupled to the power source VDD, and a drain terminal coupled to the I/O pad 202. The ESD protection control circuit 400 comprises a resistor R and a capacitor C, which are coupled between the power source VDD and the ground VSS. The ESD protection control circuit 400 further comprises a lock transistor TL. The lock transistor TL is a PMOS having a gate terminal coupled to a connection terminal between the resistor R and the capacitor C, a source terminal coupled to the power source VDD, and a drain terminal coupled to a gate terminal of the second output driver transistor M2. In response to a negative electrostatic disturbance at the I/O pad 202, the connection terminal between the resistor R and the capacitor C is low (0), so that the lock transistor TL is turned on to lock (turn off) the second output driver transistor M2. The ESD current I_ESD is bypassed through the safe path, and the second output driver transistor M2 is well protected from damage by the ESD event.

The ESD protection control circuit 400 further has a disable transistor TD (optional). The disable transistor TD is a PMOS having a source terminal coupled to the power source VDD, a drain terminal coupled to the gate terminal of the lock transistor TL, and a gate terminal. In FIG. 4A, the disable transistor TD does not work. The ESD protection control circuit 400 operates to deal with the electrostatic disturbance.

FIG. 4B shows the normal operations of the output driver. A de-asserted signal '0' is coupled to the gate terminal of the disable transistor TD. Accordingly, the ESD control circuit 400 is disabled without affecting the normal operations of the output driver.

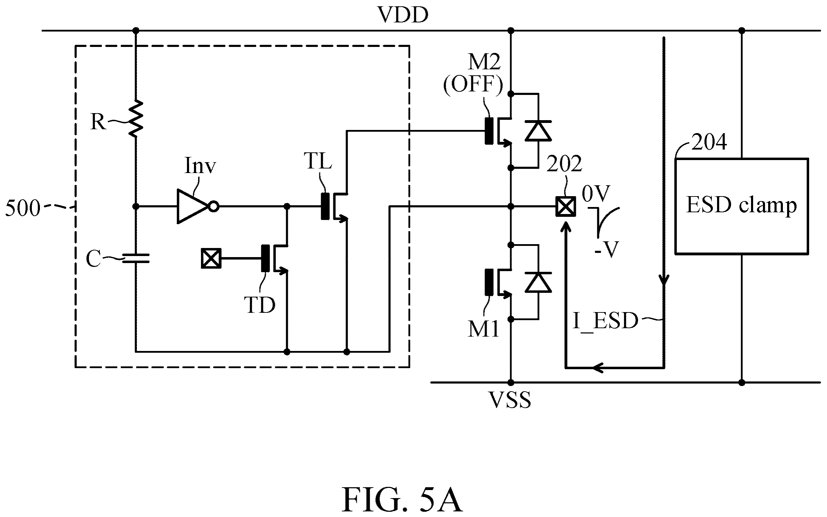

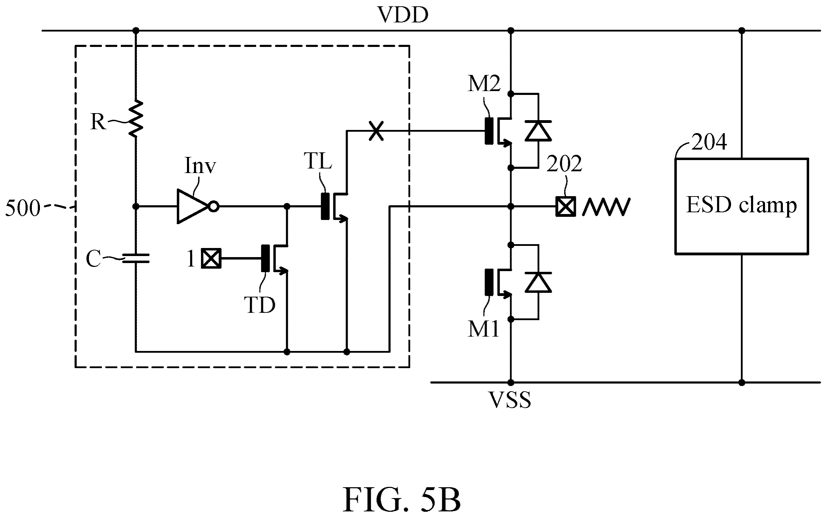

In some exemplary embodiments, the second output driver transistor M2 is implemented by an NMOS, different from the PMOS M2 of FIG. 4A and FIG. 4B. FIG. 5A and FIG. 5B show the ESD locking for the NMOS M2 in accordance with an exemplary embodiment of the disclosure.

Referring to FIG. 5A, in response to negative electrostatic disturbance (e.g., from 0V to -V) at the I/O pad 202, the ESD protection control circuit 500 turns off the NMOS M2, and thereby an electrostatic discharge current I_ESD from the power source VDD is directed to the I/O pad 202 through the ESD clamp 204 and a parasitic diode of the first output driver transistor M1. The weak NMOS M2 is protected from damage.

The second output driver transistor M2, implemented by an NMOS, has a drain terminal coupled to the power source VDD, and a source terminal coupled to the I/O pad 202. The ESD protection control circuit 500 comprises a resistor R and a capacitor C coupled between the power source VDD and the I/O pad 202. The ESD protection control circuit 500 further has an inverter Inv and a lock transistor TL. The inverter Inv has an input terminal coupled to a connection terminal between the resistor R and the capacitor C. The lock transistor TL is an NMOS having a gate terminal coupled to an output terminal of the inverter Inv, a drain terminal coupled to a gate terminal of the NMOS M2, and a source terminal coupled to the I/O pad 202. In response to a negative electrostatic disturbance at the I/O pad 202, the connection terminal between the resistor R and the capacitor C is pulled down, so that the output of the inverter Inv is pulled high to turn on the lock transistor TL to lock (turn off) the NMOS M2. The ESD current I_ESD is bypassed through the safe path, and the NMOS M2 is well protected from damage by the ESD event.

The ESD protection control circuit 500 further has a disable transistor TD (optional). The disable transistor TD is an NMOS having a source terminal coupled to the I/O pad 202, a drain terminal coupled to the gate terminal of the lock transistor TL, and a gate terminal. In FIG. 5A, the disable transistor TD does not work. The ESD protection control circuit 500 operates to deal with the electrostatic disturbance.

FIG. 5B shows the normal operations of the output driver. An asserted signal '1' is coupled to the gate terminal of the disable transistor TD. Accordingly, the ESD control circuit 500 is disabled without affecting the normal operations of the output driver.

In some exemplary embodiments, the ESD protection may be achieved by triggering the strong transistors to provide a safe path for the ESD current.

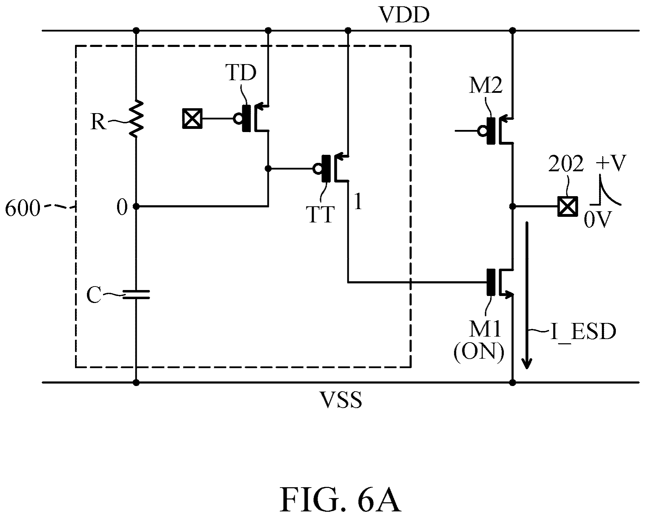

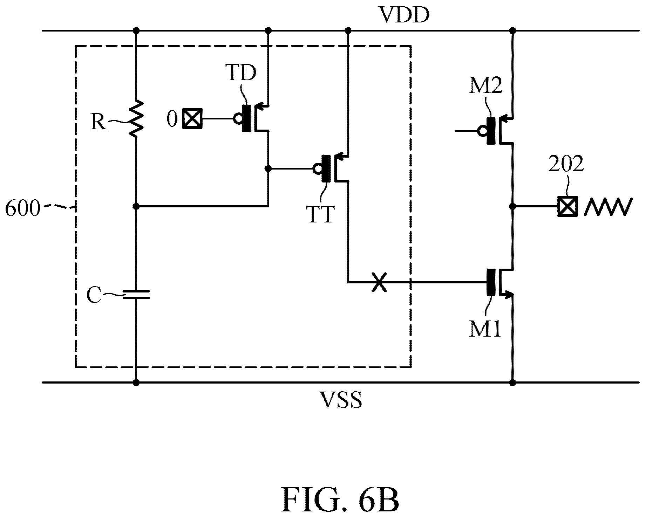

FIG. 6A and FIG. 6B show the ESD protection based on MOS triggering of the first output driver transistor M1 in accordance with an exemplary embodiment of the disclosure. Referring to FIG. 6A, in response to positive electrostatic disturbance (e.g., from 0V to +V) at the I/O pad 202, the ESD protection control circuit 600 turns on the first output driver transistor M1, and thereby an electrostatic discharge current I_ESD from the I/O pad 202 is directed to the ground VSS through the first output driver transistor M1. No additional ESD pull-down circuit is required between the I/O pad 202 and the ground VSS.

In this example, the first output driver transistor M1 is an NMOS. The ESD protection control circuit 600 has a resistor R and a capacitor C coupled between the power source VDD and the ground VSS. The ESD protection control circuit 600 further has a trigger transistor TT. The trigger transistor TT is a PMOS having a gate terminal coupled to a connection terminal between the resistor R and the capacitor C, a source terminal coupled to the power source VDD, and a drain terminal coupled to the gate terminal of the first output driver transistor M1. In response to the positive electrostatic disturbance at the I/O pad 202, the connection terminal between the resistor R and the capacitor C is low (0), so that the trigger transistor TT is turned on to trigger (turn on) the first output driver transistor M1. The ESD current I_ESD is safely directed to the ground VSS.

The ESD protection control circuit 600 further has a disable transistor TD (optional). The disable transistor TD is a PMOS having a source terminal coupled to the power source VDD, a drain terminal coupled to the gate terminal of the trigger transistor TT, and a gate terminal. In FIG. 6A, the disable transistor TD does not work. The ESD protection control circuit 600 operates to deal with the electrostatic disturbance.

FIG. 6B shows the normal operations of the output driver. A de-asserted signal '0' is coupled to the gate terminal of the disable transistor TD. Accordingly, the ESD control circuit 600 is disabled without affecting the normal operations of the output driver.

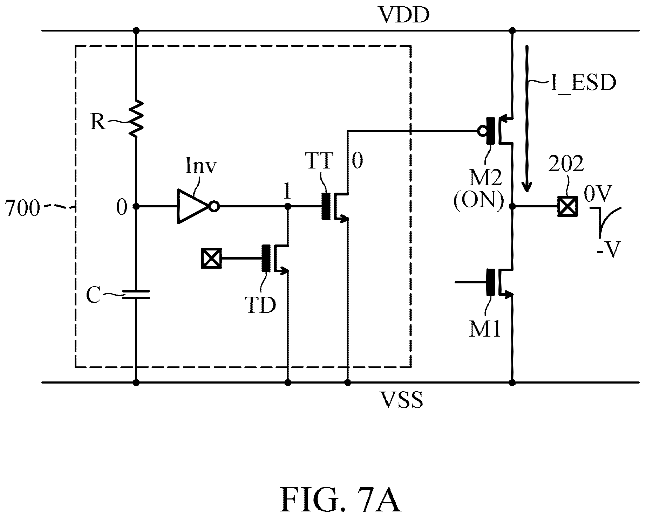

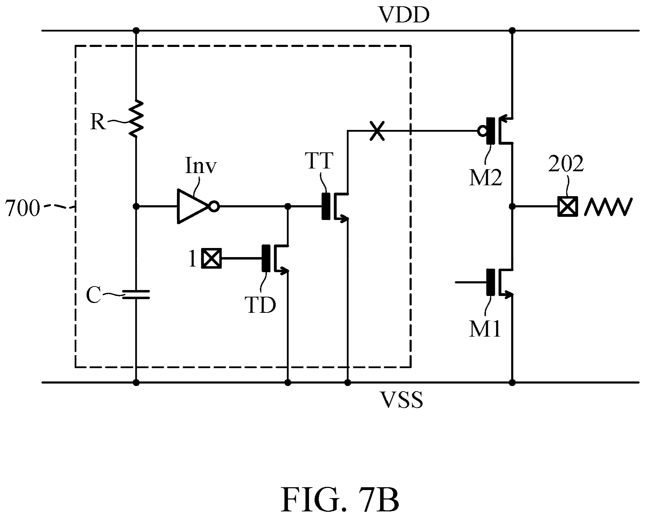

FIG. 7A and FIG. 7B show the ESD protection based on MOS triggering of the second output driver transistor M2 in accordance with an exemplary embodiment of the disclosure. Referring to FIG. 7A, in response to negative electrostatic disturbance (e.g., from 0V to -V) at the I/O pad 202, the ESD protection control circuit 700 turns on the second output driver transistor M2, and thereby an electrostatic discharge current I_ESD from the power source VDD is directed to the I/O pad 202 through the second output driver transistor M2. No additional ESD pull-up circuit is required between the I/O pad 202 and the power source VDD.

In this example, the second output driver transistor M2 is a PMOS. The ESD protection control circuit 700 has a resistor R and a capacitor C coupled between the power source VDD and the ground VSS. The ESD protection control circuit 700 further has an inverter Inv and a trigger transistor TT. The inverter Inv has an input terminal coupled to a connection terminal between the resistor R and the capacitor C. The trigger transistor TT is an NMOS, having a gate terminal coupled to an output terminal of the inverter Inv, a drain terminal coupled to a gate terminal of the second output driver transistor M2, and a source terminal coupled to the ground VSS. In response to a negative electrostatic disturbance at the I/O pad 202, the connection terminal between the resistor R and the capacitor C is low (0), so that the inverter Inv outputs high (1) to turn on the trigger transistor TT to trigger (turn on) the second output driver transistor M2. The ESD current I_ESD is safely directed from the power source VDD to the I/O pad 202.

The ESD protection control circuit 700 further has a disable transistor TD (optional). The disable transistor TD is an NMOS having a source terminal coupled to the ground VSS, a drain terminal coupled to the gate terminal of the trigger transistor TT, and a gate terminal. In FIG. 7A, the disable transistor TD does not work. The ESD protection control circuit 700 operates to deal with the electrostatic disturbance.

FIG. 7B shows the normal operations of the output driver. An asserted signal '1' is coupled to the gate terminal of the disable transistor TD. Accordingly, the ESD control circuit 700 is disabled without affecting the normal operations of the output driver.

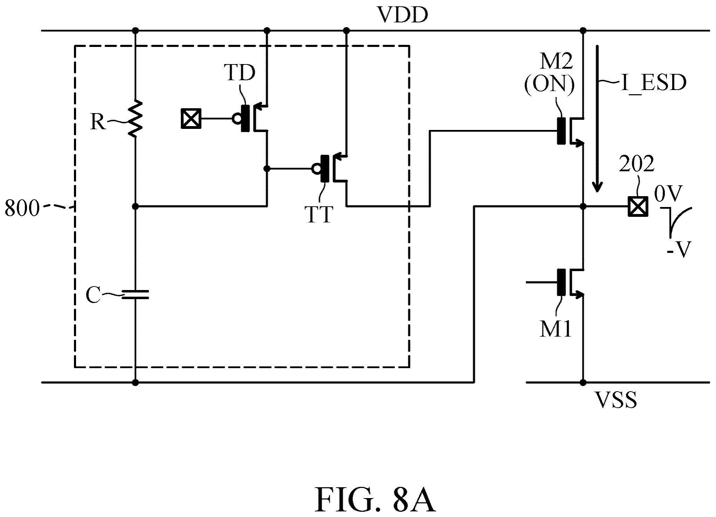

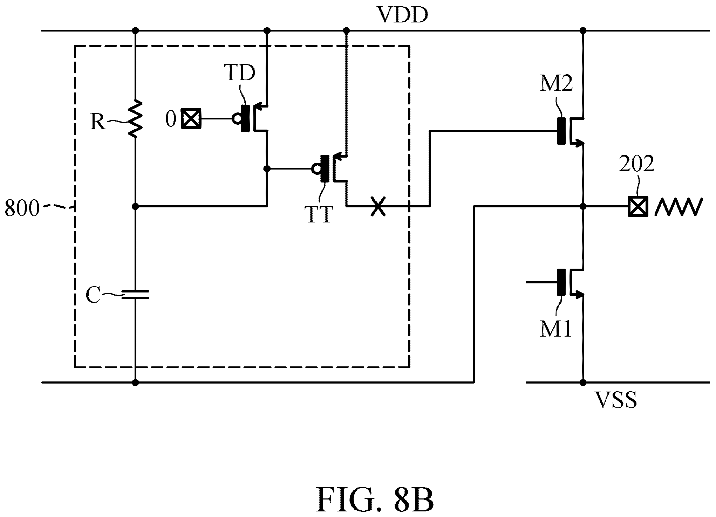

As for the example wherein the second output driver transistor M2 is an NMOS, FIG. 8A and FIG. 8B show the ESD protection based on MOS triggering of the NMOS M2 in accordance with an exemplary embodiment of the disclosure.

Referring to FIG. 8A, in response to negative electrostatic disturbance (e.g., from 0V to -V) at the I/O pad 202, the ESD protection control circuit 800 turns on the NMOS M2, and thereby an electrostatic discharge current I_ESD from the power source VDD is directed to the I/O pad 202 through the NMOS M2. No additional ESD pull-up circuit is required between the I/O pad 202 and the power source VDD.

The ESD protection control circuit 800 comprises a resistor R and a capacitor C coupled between the power source VDD and the I/O pad 202. The ESD protection control circuit 800 further has a trigger transistor TT. The trigger transistor TT is a PMOS having a gate terminal coupled to a connection terminal between the resistor R and the capacitor C, a source terminal coupled to the power source VDD, and a drain terminal coupled to the gate terminal of the NMOS M2. In response to the negative electrostatic disturbance at the I/O pad 202, the connection terminal between the resistor R and the capacitor C is pulled down, so that the trigger transistor TT is turned on to trigger (turn on) the NMOS M2. The ESD current I_ESD is safely directed from the power source VDD to the I/O pad 202 through the NMOS M2.

The ESD protection control circuit 800 further has a disable transistor TD (optional). The disable transistor TD is a PMOS having a source terminal coupled to the power source VDD, a drain terminal coupled to the gate terminal of the trigger transistor TT, and a gate terminal. In FIG. 8A, the disable transistor TD does not work. The ESD protection control circuit 800 operates to deal with the electrostatic disturbance.

FIG. 8B shows the normal operations of the output driver. A de-asserted signal '0' is coupled to the gate terminal of the disable transistor TD. Accordingly, the ESD control circuit 800 is disabled without affecting the normal operations of the output driver.

Any ESD protection design without using an ESD pull-up circuit between the power source VDD and the I/O pad or an ESD pull-down circuit between the I/O pad and the ground VSS may relate to the disclosure. A chip with the proposed ESD protection control circuit enabled in response electrostatic disturbance at the I/O pad should be considered within the scope of the disclosure.

While the disclosure has been described by way of example and in terms of the preferred embodiments, it should be understood that the disclosure is not limited to the disclosed embodiments. On the contrary, it is intended to cover various modifications and similar arrangements. Therefore, the scope of the appended claims should be accorded the broadest interpretation so as to encompass all such modifications and similar arrangements.

Various embodiments are set out in the following numbered clauses.

Clause 1. A chip with electrostatic discharge protection, comprising: an output driver, having a first output driver transistor coupled between an input/output pad of the chip and ground, and a second output driver transistor coupled between a power source and the input/output pad; and an electrostatic discharge protection control circuit, having a first output terminal coupled to a control terminal of the first output driver transistor, to control the first output driver transistor for electrostatic discharge protection, wherein the electrostatic discharge protection control circuit is enabled in response to electrostatic disturbance at the input/output pad.

Clause 2. The chip with electrostatic discharge protection of Clause 1, further comprising: an electrostatic discharge clamp, coupled between the power source and the ground; wherein, the electrostatic discharge protection control circuit turns off the first output driver transistor in response to positive electrostatic disturbance at the input/output pad, and thereby an electrostatic discharge current from the input/output pad is directed to the ground through a parasitic diode of the second output driver transistor and the electrostatic discharge clamp.

Clause 3. The chip with electrostatic discharge protection of Clause 2, wherein:
the first output driver transistor is an n-type metal-oxide-semiconductor field-effect transistor, having a drain terminal coupled to the input/output pad, and a source terminal coupled to the ground; and the electrostatic discharge protection control circuit comprises: a resistor and a capacitor, coupled between the power source and the ground; an inverter, having an input terminal coupled to a connection terminal between the resistor and the capacitor; and a lock transistor, which is an n-type metal-oxide-semiconductor field-effect transistor having a gate terminal coupled to an output terminal of the inverter, a drain terminal coupled to a gate terminal of the first output driver transistor, and a source terminal coupled to the ground.

Clause 4. The chip with electrostatic discharge protection of Clause 3, wherein the electrostatic discharge protection control circuit further comprises: a disable transistor, which is an n-type metal-oxide-semiconductor field-effect transistor having a source terminal coupled to the ground, a drain terminal coupled to the gate terminal of the lock transistor, and a gate terminal receiving an asserted signal to disable the electrostatic discharge protection control circuit for normal operation of the output driver.

Clause 5. The chip with electrostatic discharge protection of Clause 1, wherein: the electrostatic discharge protection control circuit turns on the first output driver transistor in response to positive electrostatic disturbance at the input/output pad, and thereby an electrostatic discharge current from the input/output pad is directed to the ground through the first output driver transistor.

Clause 6. The chip with electrostatic discharge protection of Clause 5, wherein: the first output driver transistor is an n-type metal-oxide-semiconductor field-effect transistor, having a drain terminal coupled to the input/output pad, and a source terminal coupled to the ground; and the electrostatic discharge protection control circuit comprises: a resistor and a capacitor, coupled between the power source and the ground; and a trigger transistor, which is a p-type metal-oxide-semiconductor field-effect transistor having a gate terminal coupled to a connection terminal between the resistor and the capacitor, a source terminal coupled to the power source, and a drain terminal coupled to a gate terminal of the first output driver transistor.

Clause 7. The chip with electrostatic discharge protection of Clause 6, wherein the electrostatic discharge protection control circuit further comprises: a disable transistor, which is a p-type metal-oxide-semiconductor field-effect transistor having a source terminal coupled to the power source, a drain terminal coupled to the gate terminal of the trigger transistor, and a gate terminal receiving a de-asserted signal to disable the electrostatic discharge protection control circuit for normal operation of the output driver.

Clause 8. The chip with electrostatic discharge protection of Clause 1, wherein: the electrostatic discharge protection control circuit further has a second output terminal coupled to a control terminal of the second output driver transistor, to control the second output driver transistor for electrostatic discharge protection.

Clause 9. The chip with electrostatic discharge protection of Clause 8, further comprising: an electrostatic discharge clamp, coupled between the power source and the ground; wherein, the electrostatic discharge protection control circuit turns off the second output driver transistor in response to negative electrostatic disturbance at the input/output pad, and thereby an electrostatic discharge current from the power source is directed to the input/output pad through the electrostatic discharge clamp and a parasitic diode of the first output driver transistor.

Clause 10. The chip with electrostatic discharge protection of Clause 9, wherein: the second output driver transistor is a p-type metal-oxide-semiconductor field-effect transistor, having a source terminal coupled to the power source, and a drain terminal coupled to the input/output pad; and the electrostatic discharge protection control circuit comprises: a resistor and a capacitor, coupled between the power source and the ground; a lock transistor, which is a p-type metal-oxide-semiconductor field-effect transistor having a gate terminal coupled to a connection terminal between the resistor and the capacitor, a source terminal coupled to the power source, and a drain terminal coupled to a gate terminal of the second output driver transistor.

Clause 11. The chip with electrostatic discharge protection of Clause 10, wherein the electrostatic discharge protection control circuit further comprises: a disable transistor, which is a p-type metal-oxide-semiconductor field-effect transistor having a source terminal coupled to the power source, a drain terminal coupled to the gate terminal of the lock transistor, and a gate terminal receiving a de-asserted signal to disable the electrostatic discharge protection control circuit for normal operation of the output driver.

Clause 12. The chip with electrostatic discharge protection of Clause 9, wherein: the second output driver transistor is an n-type metal-oxide-semiconductor field-effect transistor, having a drain terminal coupled to the power source, and a source terminal coupled to the input/output pad; and the electrostatic discharge protection control circuit comprises: a resistor and a capacitor, coupled between the power source and the input/output pad; an inverter, having an input terminal coupled to a connection terminal between the resistor and the capacitor; and a lock transistor, which is an n-type metal-oxide-semiconductor field-effect transistor having a gate terminal coupled to an output terminal of the inverter, a drain terminal coupled to a gate terminal of the second output driver transistor, and a source terminal coupled to the input/output pad.

Clause 13. The chip with electrostatic discharge protection of Clause 12, wherein the electrostatic discharge protection control circuit further comprises: a disable transistor, which is an n-type metal-oxide-semiconductor field-effect transistor having a source terminal coupled to the input/output pad, a drain terminal coupled to the gate terminal of the lock transistor, and a gate terminal receiving an asserted signal to disable the electrostatic discharge protection control circuit for normal operation of the output driver.

Clause 14. The chip with electrostatic discharge protection of Clause 8, wherein: the electrostatic discharge protection control circuit turns on the second output driver transistor in response to negative electrostatic disturbance at the input/output pad, and thereby an electrostatic discharge current from the power source is directed to the input/output pad through the second output driver transistor.

Clause 15. The chip with electrostatic discharge protection of Clause 14, wherein: the second output driver transistor is a p-type metal-oxide-semiconductor field-effect transistor, having a source terminal coupled to the power source, and a drain terminal coupled to the input/output pad; and the electrostatic discharge protection control circuit comprises: a resistor and a capacitor, coupled between the power source and the ground; an inverter, having an input terminal coupled to a connection terminal between the resistor and the capacitor; and a trigger transistor, which is an n-type metal-oxide-semiconductor field-effect transistor having a gate terminal coupled to an output terminal of the inverter, a drain terminal coupled to a gate terminal of the second output driver transistor, and a source terminal coupled to the ground.

Clause 16. The chip with electrostatic discharge protection of Clause 15, wherein the electrostatic discharge protection control circuit further comprises: a disable transistor, which is an n-type metal-oxide-semiconductor field-effect transistor having a source terminal coupled to the ground, a drain terminal coupled to the gate terminal of the trigger transistor, and a gate terminal receiving an asserted signal to disable the electrostatic discharge protection control circuit for normal operation of the output driver.

Clause 17. The chip with electrostatic discharge protection of Clause 14, wherein: the second output driver transistor is an n-type metal-oxide-semiconductor field-effect transistor, having a drain terminal coupled to the power source, and a source terminal coupled to the input/output pad; and the electrostatic discharge protection control circuit comprises: a resistor and a capacitor, coupled between the power source and the input/output pad; and a trigger transistor, which is a p-type metal-oxide-semiconductor field-effect transistor having a gate terminal coupled to a connection terminal between the resistor and the capacitor, a source terminal coupled to the power source, and a drain terminal coupled to a gate terminal of the second output driver transistor.

Clause 18. The chip with electrostatic discharge protection of Clause 17, wherein the electrostatic discharge protection control circuit further comprises: a disable transistor, which is a p-type metal-oxide-semiconductor field-effect transistor having a source terminal coupled to the power source, a drain terminal coupled to the gate terminal of the trigger transistor, and a gate terminal receiving a de-asserted signal to disable the electrostatic discharge protection control circuit for normal operation of the output driver.

Clause 19. A chip with electrostatic discharge protection, comprising: an output driver, having a first output driver transistor coupled between an input/output pad of the chip and ground, and a second output driver transistor coupled between a power source and the input/output pad; and an electrostatic discharge protection control circuit, having an output terminal coupled to a control terminal of the second output driver transistor, to control the second output driver transistor for electrostatic discharge protection, wherein the electrostatic discharge protection control circuit is enabled in response to electrostatic disturbance at the input/output pad.

Clause 20. The chip with electrostatic discharge protection of Clause 19, further comprising: an electrostatic discharge clamp, coupled between the power source and the ground; wherein, the electrostatic discharge protection control circuit turns off the second output driver transistor in response to negative electrostatic disturbance at the input/output pad, and thereby an electrostatic discharge current from the power source is directed to the input/output pad through the electrostatic discharge clamp and a parasitic diode of the first output driver transistor.

Clause 21. The chip with electrostatic discharge protection of Clause 19, wherein: the electrostatic discharge protection control circuit turns on the second output driver transistor in response to negative electrostatic disturbance at the input/output pad, and thereby an electrostatic discharge current from the power source is directed to the input/output pad through the second output driver transistor.

## Claims

1. A chip (200) with electrostatic discharge protection, comprising an output driver having a first output driver transistor (M1) coupled between an input/output pad (202) of the chip (200) and ground, and a second output driver transistor (M2) coupled between a power source (VDD) and the input/output pad (202), wherein the chip (200) is **characterized in** further comprising:
an electrostatic discharge protection control circuit (206, 300, 400, 500, 600, 700, 800), having a first output terminal (ESD_CS1) coupled to a control terminal of the first output driver transistor (M1), to control the first output driver transistor (M1) for electrostatic discharge protection,
wherein the electrostatic discharge protection control circuit (206, 300, 400, 500, 600, 700, 800) is enabled in response to electrostatic disturbance at the input/output pad (202).

2. The chip (200) with electrostatic discharge protection as claimed in claim 1, further comprising:
an electrostatic discharge clamp (204), coupled between the power source (VDD) and the ground;
wherein, the electrostatic discharge protection control circuit (206, 300) turns off the first output driver transistor (M1) in response to positive electrostatic disturbance at the input/output pad (202), and thereby an electrostatic discharge current from the input/output pad (202) is directed to the ground through a parasitic diode of the second output driver transistor (M2) and the electrostatic discharge clamp (204).

3. The chip (200) with electrostatic discharge protection as claimed in claim 2, wherein:
the first output driver transistor (M1) is an n-type metal-oxide-semiconductor field-effect transistor, having a drain terminal coupled to the input/output pad (202), and a source terminal coupled to the ground; and
the electrostatic discharge protection control circuit (206, 300) comprises:
a resistor (R) and a capacitor (C), coupled between the power source (VDD) and the ground;
an inverter (Inv), having an input terminal coupled to a connection terminal between the resistor (R) and the capacitor (C); and
a lock transistor (TL), which is an n-type metal-oxide-semiconductor field-effect transistor having a gate terminal coupled to an output terminal of the inverter (Inv), a drain terminal coupled to a gate terminal of the first output driver transistor (M1), and a source terminal coupled to the ground.

4. The chip (200) with electrostatic discharge protection as claimed in claim 1, wherein:
the electrostatic discharge protection control circuit (206, 600) turns on the first output driver transistor (M1) in response to positive electrostatic disturbance at the input/output pad (202), and thereby an electrostatic discharge current from the input/output pad (202) is directed to the ground through the first output driver transistor (M1).

5. The chip (200) with electrostatic discharge protection as claimed in claim 4, wherein:
the first output driver transistor (M1) is an n-type metal-oxide-semiconductor field-effect transistor, having a drain terminal coupled to the input/output pad (202), and a source terminal coupled to the ground; and
the electrostatic discharge protection control circuit (206, 600) comprises:
a resistor (R) and a capacitor (C), coupled between the power source (VDD) and the ground; and
a trigger transistor (TT), which is a p-type metal-oxide-semiconductor field-effect transistor having a gate terminal coupled to a connection terminal between the resistor (R) and the capacitor (C), a source terminal coupled to the power source (VDD), and a drain terminal coupled to a gate terminal of the first output driver transistor (M1).

6. The chip (200) with electrostatic discharge protection as claimed in claim 1, wherein:
the electrostatic discharge protection control circuit (206, 300, 400, 500, 600, 700, 800) further has a second output terminal (ESD_CS2) coupled to a control terminal of the second output driver transistor (M2), to control the second output driver transistor (M2) for electrostatic discharge protection.

7. The chip (200) with electrostatic discharge protection as claimed in claim 6, further comprising:
an electrostatic discharge clamp (204), coupled between the power source (VDD) and the ground;
wherein, the electrostatic discharge protection control circuit (206, 400, 500) turns off the second output driver transistor (M2) in response to negative electrostatic disturbance at the input/output pad (202), and thereby an electrostatic discharge current from the power source (VDD) is directed to the input/output pad (202) through the electrostatic discharge clamp (204) and a parasitic diode of the first output driver transistor (M1).

8. The chip (200) with electrostatic discharge protection as claimed in claim 7, wherein:
the second output driver transistor (M2) is a p-type metal-oxide-semiconductor field-effect transistor, having a source terminal coupled to the power source (VDD), and a drain terminal coupled to the input/output pad (202); and
the electrostatic discharge protection control circuit (206, 400) comprises:
a resistor (R) and a capacitor (C), coupled between the power source (VDD) and the ground;
a lock transistor (TL), which is a p-type metal-oxide-semiconductor field-effect transistor having a gate terminal coupled to a connection terminal between the resistor (R) and the capacitor (C), a source terminal coupled to the power source (VDD), and a drain terminal coupled to a gate terminal of the second output driver transistor (M2).

9. The chip (200) with electrostatic discharge protection as claimed in claim 7, wherein:
the second output driver transistor (M2) is an n-type metal-oxide-semiconductor field-effect transistor, having a drain terminal coupled to the power source (VDD), and a source terminal coupled to the input/output pad (202); and
the electrostatic discharge protection control circuit (206, 500) comprises:
a resistor (R) and a capacitor (C), coupled between the power source (VDD) and the input/output pad (202);
an inverter (Inv), having an input terminal coupled to a connection terminal between the resistor (R) and the capacitor (C); and
a lock transistor (TL), which is an n-type metal-oxide-semiconductor field-effect transistor having a gate terminal coupled to an output terminal of the inverter (Inv), a drain terminal coupled to a gate terminal of the second output driver transistor (M2), and a source terminal coupled to the input/output pad (202).

10. The chip (200) with electrostatic discharge protection as claimed in claim 6, wherein:
the electrostatic discharge protection control circuit (206, 700, 800) turns on the second output driver transistor (M2) in response to negative electrostatic disturbance at the input/output pad (202), and thereby an electrostatic discharge current from the power source (VDD) is directed to the input/output pad (202) through the second output driver transistor (M2).

11. The chip (200) with electrostatic discharge protection as claimed in claim 10, wherein:
the second output driver transistor (M2) is a p-type metal-oxide-semiconductor field-effect transistor, having a source terminal coupled to the power source (VDD), and a drain terminal coupled to the input/output pad (202); and
the electrostatic discharge protection control circuit (206, 700) comprises:
a resistor (R) and a capacitor (C), coupled between the power source (VDD) and the ground;
an inverter (Inv), having an input terminal coupled to a connection terminal between the resistor (R) and the capacitor (C); and
a trigger transistor (TT), which is an n-type metal-oxide-semiconductor field-effect transistor having a gate terminal coupled to an output terminal of the inverter (Inv), a drain terminal coupled to a gate terminal of the second output driver transistor (M2), and a source terminal coupled to the ground.

12. The chip (200) with electrostatic discharge protection as claimed in claim 10, wherein:
the second output driver transistor (M2) is an n-type metal-oxide-semiconductor field-effect transistor, having a drain terminal coupled to the power source (VDD), and a source terminal coupled to the input/output pad (202); and
the electrostatic discharge protection control circuit (206, 800) comprises:
a resistor (R) and a capacitor (C), coupled between the power source (VDD) and the input/output pad (202); and
a trigger transistor (TT), which is a p-type metal-oxide-semiconductor field-effect transistor having a gate terminal coupled to a connection terminal between the resistor (R) and the capacitor (C), a source terminal coupled to the power source (VDD), and a drain terminal coupled to a gate terminal of the second output driver transistor (M2).

13. A chip (200) with electrostatic discharge protection, comprising an output driver having a first output driver transistor (M1) coupled between an input/output pad (202) of the chip and ground, and a second output driver transistor (M2) coupled between a power source (VDD) and the input/output pad (202), wherein the chip is **characterized in** further comprising:
an electrostatic discharge protection control circuit (206, 300, 400, 500, 600, 700, 800), having an output terminal (ESD_CS2) coupled to a control terminal of the second output driver transistor (M2), to control the second output driver transistor (M2) for electrostatic discharge protection,
wherein the electrostatic discharge protection control circuit (206, 300, 400, 500, 600, 700, 800) is enabled in response to electrostatic disturbance at the input/output pad (202).

14. The chip (200) with electrostatic discharge protection as claimed in claim 13, further comprising:
an electrostatic discharge clamp (204), coupled between the power source (VDD) and the ground;
wherein, the electrostatic discharge protection control circuit (206, 400, 500) turns off the second output driver transistor (M2) in response to negative electrostatic disturbance at the input/output pad (202), and thereby an electrostatic discharge current from the power source (VDD) is directed to the input/output pad (202) through the electrostatic discharge clamp (204) and a parasitic diode of the first output driver transistor (M1).

15. The chip (200) with electrostatic discharge protection as claimed in claim 13, wherein:
the electrostatic discharge protection control circuit (206, 700, 800) turns on the second output driver transistor (M2) in response to negative electrostatic disturbance at the input/output pad (202), and thereby an electrostatic discharge current from the power source (VDD) is directed to the input/output pad (202) through the second output driver transistor (M2).
